# EUROPEAN PATENT APPLICATION

(11) **EP 1 113 715 A1**
(43) Date of publication of application: **04.07.2001**
(21) Application number: 99830832.4
(22) Date of filing: 31.12.1999
(51) Int. Cl.: H05K 9/00, E06B 5/18

(54) **Method for shielding glass surfaces of buildings from electromagnetic waves and glass panel for the building industry that carries out this method**

(71) Applicant: Valli Zabban s.p.a., 50019 Sesto Fiorentino FI (IT)
(72) Inventor: Vignudelli, Adriano, 41057 Spilamberto MO (IT); Olmi, Eugenio, 59100 Prato PO (IT)
(74) Representative: Celestino, Marco

(57) **Abstract**

Glass panel (3) for the building industry to make doors or windows (1) with electromagnetic shielding. The panel (3) comprises inside a shielding net (4) of lead wire capable of contacting the metal frame (2) of the door or window (1). The shielding net (4) is made of woven lead wire (5). The wire (5) of the net (4) is formed by a wire core in fibres or in metal plated with highly conductive metals, chosen among precious inoxidizable metal such as gold, platinum, titanium, rhodium, cobalt. Alternatively the wire (5) can be of stainless steel with good electrical conductivity. The net (4) allows an appropriate shielding from electromagnetic waves directed towards/from rooms closed by doors or windows (1). The panel (3) can be formed by a first glass sheet, a second glass sheet and a distancing frame that form an air chamber. The net (4) is located between the sheet (11) and the frame (13).

## Description

### Field of the invention

The present invention relates to a method for shielding glass surfaces of buildings from electromagnetic waves.

Furthermore, the invention relates to a glass panel for the building industry that carries out this method.

### Background of the invention

The problem is felt of shielding houses and offices from electromagnetic waves, whose negative effects on health and on well-being, notwithstanding not yet completely understood, are feared by people.

In particular, houses and offices are the places where people spend most of time, and then where the exposition is the largest.

New buildings have always thin walls, even if rugged enough, and are substantially permeable to electromagnetic waves.

In particular, roofs of buildings often support repeaters or other antennas that emit electromagnetic waves, whereby inhabitants are more exposed to this type of radiation. Near buildings there are sometimes high voltage lines, that create intense and variable electric and magnetic fields.

Furthermore, instruments and apparatus electronic are negatively affected by the presence of electromagnetic waves.

In a building, the points more permeable to electromagnetic waves are the glass surfaces.

It is furthermore in certain cases felt the problem of shielding from radio transmissions rooms where secret discussions occur, in which microphones could be installed. Owing to the high permeability to radio frequencies of glass surfaces of buildings to electromagnetic waves, microphones even very small installed in a room could transmit conversations also hundreds meter away and allow to other people to listen to them.

For achieving the object of shielding is furthermore relevant to have sufficiently transparent glass surfaces of buildings for allowing light of pass and of illuminating the rooms.

On the other hand, is felt the need of attenuating the sunlight that passes through the glass surfaces of buildings, for example by means of smoked glasses, sun blinds, shutters, etc. In particular, in houses and in the public places the attenuation of the sunlight is obtained with the systems aesthetically valuable, which can be coloured.

It is well known from US 4613530 a multiple glass panel that comprises inside a transparent conductive film used as an anti radiation shield. The transparent film is covered by antioxidant layers that give at the same time stiffness. The combination of the film and of the protective layers is kept stretched by the frame of the panel. A portion of the film protrudes from the panel and is grounded, to provide the shielding.

This type of panel overcomes in part the above problems of shielding and of transparency. However, it does not provide an attenuation of the sunlight contemporaneous to shielding partially or totally electromagnetic waves.

EP 291591 describes also an electromagnetic shield for windows of buildings, and comprises a transparent film and a grounding by means of direct connection to the metal frame of the window and to metal structural elements of the building. The transparent film is mounted directly on the glass with the superimposition of a protective film antioxidant.

It is also known the use of means for electromagnetic shielding comprising metal nets associated to the glass. However, the metal nets used in such cases are normally antiaesthetical and create an excessive attenuation of sunlight. Furthermore they are quickly oxidised and turn into a dark colour. Therefore, are suitable for cases where at the same time functions of shielding and functions esthetical, as required in the building industry.

### Summary of the invention

It is an object of the present invention to provide a method for protecting glass surfaces of buildings capable of shielding rooms from electromagnetic waves, which is easy to carry out both on existing doors or windows and on doors or windows being built.

It is another object of the present invention to provide a method for shielding glass surfaces of buildings from electromagnetic waves that allows at the same time enough transparency to light coming from the outside and, at the same time, provides an attenuation of the sunlight without the need of treating the glass and of sun blinds.

It is a further object of the present invention to provide a glass panel for the building industry that allows good permeability to light from the outside and is at the same time impermeable to electromagnetic waves.

It is a particular object of the present invention to provide a glass panel for the building industry that is easy to make and to mount to metallic doors or windows for shielding electromagnetic waves.

It is a further object of the present invention to provide a glass panel for the building industry that is aesthetically valuable and does not have the drawbacks of the panels according to the prior art, in which the problem of oxidation arises.

These and other objects are achieved by the method according to the invention that comprises a step of making a glass panel for the building industry having inside for all its extension at least a layer of net of lead wire. The net is formed by woven wire, of fibres or in metal. The wire core is plated with highly conductive metals, for example precious inoxidizable metal chosen among gold, platinum, titanium, rhodium, cobalt. Alternatively the wire can be of stainless steel with good electrical conductivity.

Being the woven net made of wire plated with a precious inoxidizable metal, there is at the same time the advantage of not requiring a step of superimposing to the net a protective film and therefore without further costs.

The maximum distance between two lead wires of the net is preferably 100-250µ whereas the diameter of the wire is advantageously set between 20 and 100µ. Therefore, since the net is woven very finely and with intrinsically coloured precious metals there is a remarkable esthetical effect.

Also the advantage of low costs is remarkable. The cost of the net plated with precious metal can be for example 10 times more than that of the net not plated, but a hundred times less than the cost of the net made directly with a wire completely of the chosen precious metal.

The method for shielding according to the invention allows the achievement of all the above objects.

According to another general aspect of the invention a glass panel for the building industry impermeable to electromagnetic waves is formed by at least a glass sheet associated to at least a layer of net of lead wire that extends for all its surface. The net is formed by woven wire of fibres or metal. The wire core is plated with highly conductive metals, for example precious inoxidizable metal chosen among gold, platinum, titanium, rhodium, cobalt. Alternatively the wire can be of stainless steel with good electrical conductivity.

The net of lead wire is advantageously located between two parallel sheets of glass. The two sheets of glass can be separated by an air chamber defined by a spacing frame , and the net of lead wire can be attached to one of the two sheets or to both.

The maximum distance between two wires of the net is variable as a function of the type of electromagnetic waves to shield and is preferably 100-250µ whereas the diameter of the wire is advantageously set between 20 and 100µ.

In a preferred embodiment, not all the net is comprised between the two sheets of glass, and precisely an edge of net protrudes from all the sides of the panel and is suitable for contacting directly the metal body of the door or window to which it is mounted.

The net edges that protrude from the panel are electrically not insulated. When mounting the panel in a recess of a door or window, it is possible to have the protruding net edges contact the metal body of the door or window, for example made of aluminium. This way the door or window form with the nets of the glass panels a single conductor, grounded by means of the grounding of the door or window same.

The net edges that protrude from the panel before being mounted to the door or window are advantageously folded in order to form a tubular net, which in step of production can be riempito cono a elemento elastico, for example a material spugnoso elastico. In tal modo, applicando the panel dentro the sede of the door or window there is that the portion tubular of net that extends about all the panel remains schiacciata dentro the sede of the door or window and contacts continuously with it owing to the pressure resilient of the material spugnoso.

Panel adiacenti can having respective net edges directly to contact electrical a to altro.

Advantageously, the net edges scoperti can be coated of conductive paste, for example based on powder of graphite, copper, silver, aluminium in order to assuring a contact also where a distancing is present.

According to another physical aspect of the invention, a lead wire suitable for being used for an embodiment of the panel shielding can be formed by a continuous wire core with the function of support and at least a layer of plated metal on the wire core. The plated metal can be a inoxidizable metal chosen among gold, platinum, titanium, rhodium, cobalt.

The continuous wire core can be chosen between:
- a wire containing conductive fibres ;
- a wire of conductive metal ;
- a wire of not conductive material coated by means of vapour plating with a layer of conductive material;
- a wire of nylon coated of silver by means of vapour plating;
- a wire of nylon coated of silver by means of passage of the wire of a aqueous solution of AgNO3 in presence of a organic or inorganic reducing substance.

The wire core, in a of the types ora elencati, is conductor of elettricità and can be plated with a inoxidizable metal by means of tecniche galvaniche.

### Brief description of the drawings

Further characteristics and the advantages of the method for shielding glass surfaces of buildings from electromagnetic waves and of the glass panel for the building industry that carries out this method according to the invention will be made clearer with the following description of an embodiment thereof, exemplifying but not limitative, with reference to attached drawings, wherein:
- Figure 1 shows a door or window metal with the glassed portion formed by four panel according to the invention;
- figure 2 shows a portion of net obtained by means of weaving conductive metal wire and the maximum distance between the meshes of wire;
- figures 2A and 2B show two embodiments of wire that can be used to make the net of figure 2;
- figure 3 shows a cross sectional view of a glass panel for the building industry comprising the shielding net according to the invention;

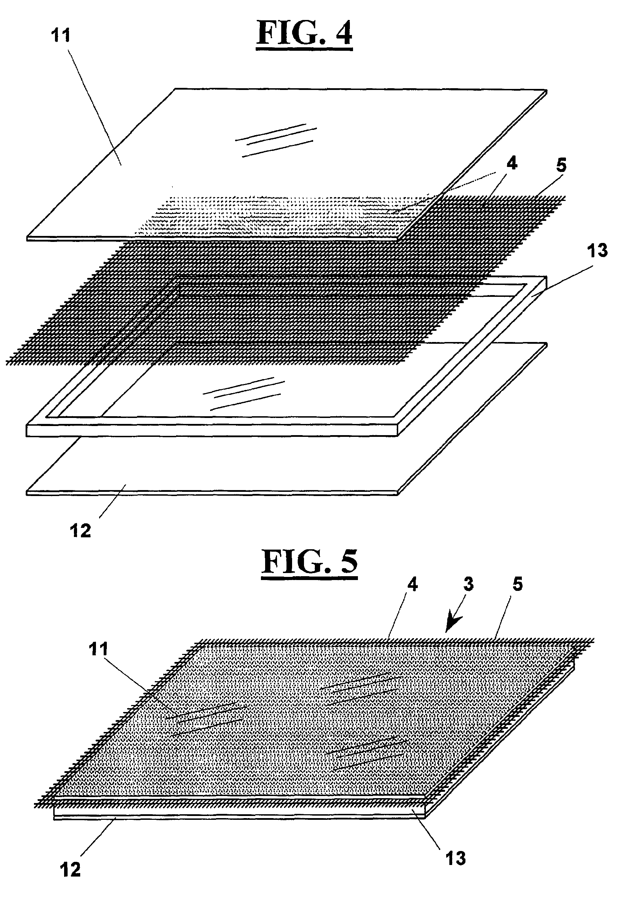

- Figure 4 shows an exploded view of the panel of figure 3;
- figure 5 shows an assembled view of the panel of figure 4 with the net edges protruding from the periphery;
- figure 6 shows the panel of figure 5 with the protruding net edges wound as a tubular shape;
- figure 7 shows the panel of figure 6 in an introduction step in the frame of a door or window.

### Description of a preferred embodiment

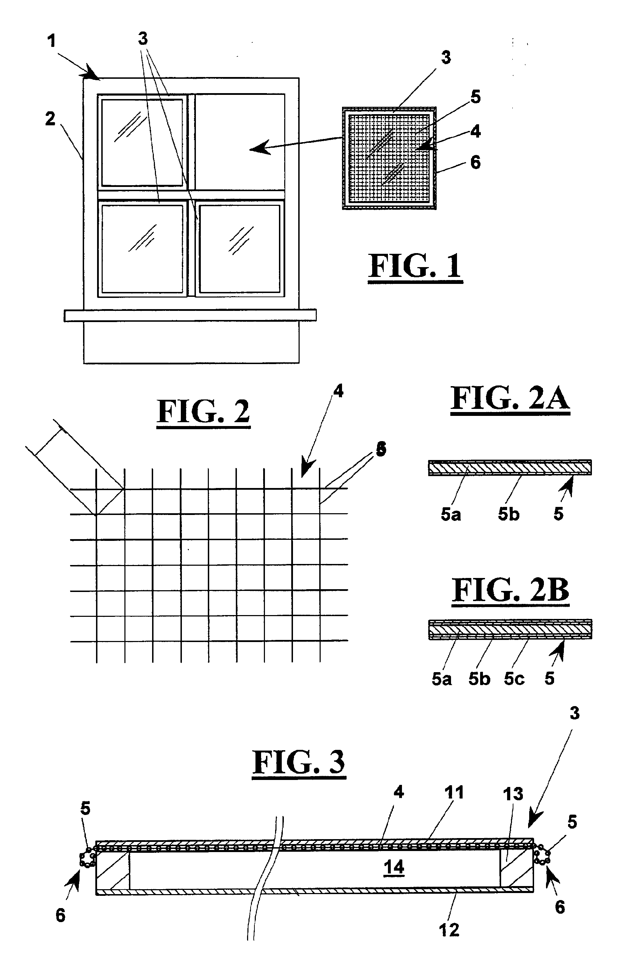

With reference to figure 1, a door or window 1 with electromagnetic shielding according to the invention comprises an outside frame 2, for example formed by aluminium sections, and a plurality of shielding panels 3, one of which is shown in position not yet mounted.

The outside frame 2 defines then four rectangular open frames made of conductive material. As described hereinafter, the panel 3 comprises inside a shielding net 4 of lead wire having edges 5 protruding from it and capable of contacting the metal frame 2 of the door or window 1.

The shielding net 4 is made of woven lead wire 6 (figure 2). The wire 5 of net 4 is formed by wire 5 in fibres or in metal plated with highly conductive metals, chosen among precious inoxidizable metal such as gold, platinum, titanium, rhodium, cobalt. Alternatively the wire 5 can be of stainless steel with good electrical conductivity.

The diameter of the wire 5 is advantageously set between 20 and 100µ. In a preferred way, the wire has diameter set between 30 and 50µ.

The net 4 allows an appropriate shielding from electromagnetic waves towards/from rooms closed by doors or windows like those shown in figure 1. The minimum thickness of the wire, for example 35 micron, and an appropriate size of the mesh of the net, for example 150-250 micron, so that net 4 is enough permeable to light this like a slightly smoked glass. This way there is the possibility of illuminating the rooms with sunlight and to obtain at the same time a attenuation of entering sunlight same.

The wire 5, that may be of gold, titanium, cobalt, platinum, rhodium, since these metals may be alloys comprising coloured known metals, allow a remarkable esthetical effect owing also to the fine thickness of the wire 5 same.

The fact that the wire 5 is plated is remarkably not expensive. In fact, the cost of the plated net with precious metal can be for example ten times more than the net not plated, but a hundred times less the cost of the net executed directly with a wire completely with the precious chosen metal.

As shown in figure 2A, the lead wire 5 for example can be formed by a continuous wire core 5a with the function of support and at least a layer 5b of metal plated on the wire core 5a. The plated metal 5b, as already said, can be gold, platinum, titanium, rhodium, cobalt.

The continuous wire core 5a can be in particular a wire containing conductive fibres or a wire of conductive metal, for example steel.

In the case the wire 5a is not a conductor, it can be advantageously covered by means of vapour plating with a layer 5c of conductive material. In particular, the wire core 5a can be a wire of nylon coated of silver 5c by means of vapour plating, in turn plated with an inoxidizable metal 5b by means of galvanic techniques.

The wire 5a, in case is of not conductive fibres, for example nylon, can be coated of the layer of silver 5c by means of passage of the wire 5a in a aqueous solution of AgNO₃ in presence of a organic or inorganic reducing substance. The solution of AgNO₃ can be complexed by addition of NH₃. During the passage of the wire in the solution of AgNO₃ gradually a reducing substance is added, that can be for example:
- ipophossite of alkaline metals,
- sulphite of alkaline metals,
- sodium borum hydride ,
- hydrochinone,
- a carboxylic acid.

With reference to figures from 3 to 6, a panel 3 is formed by a first glass sheet 11, a second glass sheet 12, a distancing frame 13 that form a air chamber 14. The net 4 is located between the sheet 11 and the frame 13.

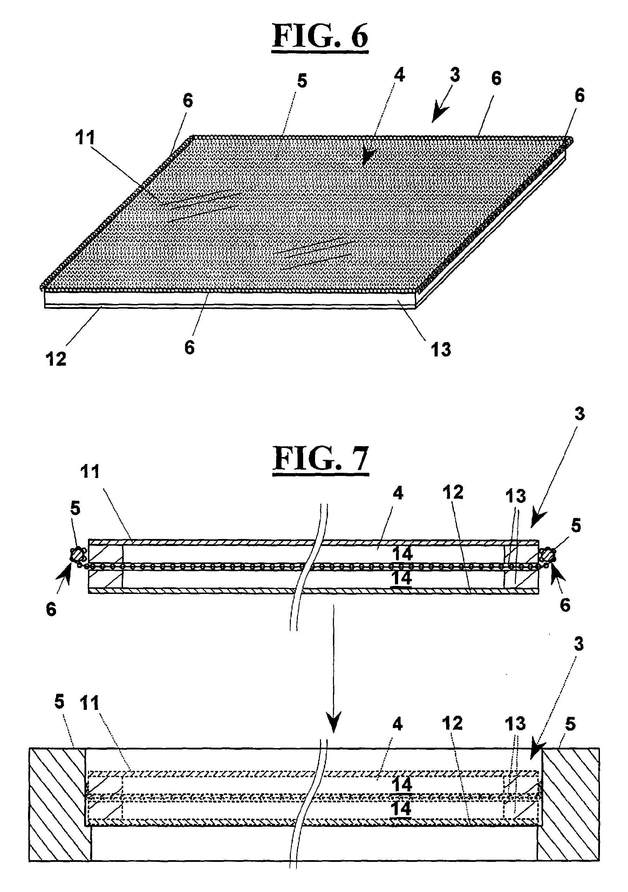

Alternatively, net 4 can be located between the two sheets of glass 11 and 12 by means of two frames as shown in figure 7.

With reference to figure 3, or to figure 7, the outer edge 6 of net 4 can be wound as a tubular net. For graphic simplicity, the circular cross section of the wire has been accentuated. It is apparent that the production of the tubular net comprises 25 to a hundred wires for each centimeter of cross section.

The form of tubular curl of the edge 6 is advantageous for its elasticity and commodity of application in the introduction the panel in the recess of a door or window (fig.1). In fact, the curl 6 has an own elasticity whereby it maintains completely in contact with the internal walls of the recess of the door or window. for accentuating this elasticity, the curl 6 can be filled of resilient gummy or spongy material, which is compressed without effort and maintains elasticity bringing in contact the net of the curl with the recess of the door or window.

The foregoing description of a specific embodiment will so fully reveal the invention according to the conceptual point of view, so that others, by applying current knowledge, will be able to modify and/or adapt for various applications such an embodiment without further research and without parting from the invention, and it is therefore to be understood that such adaptations and modifications will have to be considered as equivalent to the specific embodiment. The means and the materials to realise the different functions described herein could have a different nature without, for this reason, departing from the field of the invention. It is to be understood that the phraseology or terminology employed herein is for the purpose of description and not of limitation.

## Claims

1. Method for shielding glass surfaces of buildings from electromagnetic waves comprising making a glass panel (3) for the building industry having inside for all its extension at least a layer of net (4) of lead wire (5), said net (4) being formed by woven fibres or metal wire (5), the wire (5) being formed by a core (5a) plated with highly conductive metals, such as precious inoxidizable metal chosen among gold, platinum, titanium, rhodium, cobalt or with stainless steel with good electrical conductivity.

2. Method for shielding glass surfaces of buildings according to claim 1, wherein the maximum distance between two lead wires (5) of the net (4) is 100-250µ and wherein the diameter of the wire (5) of the net (4) is set between 20 and 100µ.

3. Method for shielding glass surfaces of buildings according to claim 1, wherein the diameter of the wire (5) of the net (4) is set between 30 and 50µ.

4. Glass panel (3) for the building industry impermeable to electromagnetic waves **characterised in that** it is formed by at least a glass sheet (11,12) associated to at least a layer of net (4) of lead wire (5) that extends for all its surface, said net (4) being formed by woven fibres or metal wire (5), the wire (5) being formed by a core (5a) plated with highly conductive metals, such as precious inoxidizable metal chosen among gold, platinum, titanium, rhodium, cobalt or with stainless steel with good electrical conductivity.

5. Panel according to claim 5, wherein the maximum distance between two lead wires (5) of the net (4) is 100-250µ and wherein the diameter of the wire (5) of the net (4) is set between 20 and 100µ.

6. Panel according to claim 5, wherein the diameter of the wire (5) of the net (4) is set between 30 and 50µ.

7. Panel according to claim 5 wherein said net (4) of lead wire (5) is located between two sheets of glass (11,12) parallel separated by a air chamber (14) defined by a distancing frame (13), said net (4) of lead wire (5) being attached to one of said two sheets (11,12).

8. Panel according to claim 5, wherein an edge (6) of said net (4) protrudes peripherally and is suitable for contacting directly the metal body of the door or window on which is mounted, said edge (6) being electrically not insulated and being suitable for contacting an appropriate recess of a door or window (1) electrically grounded.

9. Panel according to claim 8, wherein said edges (6) of net (4) that protrude from the panel before being mounted to the door or window (1) are advantageously folded in order to form a tubular net, said edges (6) of net (4) being coated of conductive paste, such as based on powder of graphite, copper, silver, aluminium, suitable for assuring an electrical contact also where a distancing is present.

10. Panel according to claim 8, wherein said edges (6) of net (4) that protrude from the panel are associated to a resilient element (6a), chosen among a spongy or gummy material, whereby said edge (6) of net (4) that extends about all the panel is compressed in the recess of the door or window (1) and contacts continuously with it Owing To The Pressure of said resilient element (6a).

11. Lead wire (5) suitable for being used for making a glass panel (3) according to the previous claims, characterised in that it is formed by a continuous wire core (5a) with the function of support and at least a layer (5b) of plated metal on said wire core (5a), said plated metal (5b) being a inoxidizable metal chosen among gold, platinum, titanium, rhodium, cobalt.

12. Lead wire (5) according to claim 11, wherein said continuous wire core (5a) is chosen between:
- a wire containing conductive fibres ;
- a wire of conductive metal ;
- a wire (5a) of not conductive material coated by means of vapour plating with a layer (5c) of conductive material;
- a wire (5a) of nylon coated of silver (5c) by means of vapour plating.
- a wire (5a) of nylon coated of silver (5c) by means of passage of the wire of a aqueous solution of AgNO3 in presence of a organic or inorganic reducing substance.
